(19) **Europäisches Patentamt / European Patent Office / Office européen des brevets**

(11) **EP 3 968 391 B1**

(12) **EUROPEAN PATENT SPECIFICATION**

(45) Date of publication and mention
of the grant of the patent:
**18.06.2025 Bulletin 2025/25**

(21) Application number: **21162358.2**

(22) Date of filing: **12.03.2021**

(51) International Patent Classification (IPC):
**H10N 10/13** (2023.01)    **H10N 10/17** (2023.01)

(52) Cooperative Patent Classification (CPC):
**H10N 10/17; H10N 10/13**

(54) **THERMOELECTRIC CONVERSION ELEMENT**

THERMOELEKTRISCHES UMWANDLUNGSELEMENT

ÉLÉMENT DE CONVERSION THERMOÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **10.09.2020 JP 2020152164**

(43) Date of publication of application:
**16.03.2022 Bulletin 2022/11**

(73) Proprietor: **Hitachi, Ltd.
Tokyo 100-8280 (JP)**

(72) Inventors:
• **NISHIDE, Akinori
Chiyoda-ku, Tokyo 100-8280 (JP)**
• **HAYAKAWA, Jun
Chiyoda-ku, Tokyo 100-8280 (JP)**
• **FUJIMORI, Tsukasa
Chiyoda-ku, Tokyo 100-8280 (JP)**

(74) Representative: **Mewburn Ellis LLP
Aurora Building
Counterslip
Bristol BS1 6BX (GB)**

(56) References cited:
EP-A1- 2 978 032    WO-A1-2013/164307
WO-A1-2015/163105    JP-A- 2011 035 203
JP-A- 2019 179 911    US-A1- 2012 145 209
US-A1- 2016 260 883    US-A1- 2019 378 967

EP 3 968 391 B1

# EP 3 968 391 B1

**Description**

BACKGROUND OF THE INVENTION

1. Field of the Invention

The present invention relates to a thermoelectric conversion element.

2. Description of the Related Art

Recently, effective utilization of exhaust heat that is generated in the process of using primary energy has become an important subject with an increased interest in energy problems, along with the use of renewable energy. An energy amount of the exhaust heat occupies approximately 60% of the primary energy, and most thereof is generated in a wide range of places such as a plant, an industrial infrastructure, consumer products, and mobility.

There are technologies for reusing various exhaust heats, and among them, a thermoelectric conversion system using a Seebeck effect in which a material generates a voltage by a temperature difference is known. The thermoelectric conversion system is not provided with a driving unit such as a turbine, and thus, has scalability and can be downsized, and is suitable for heat recovery for a wide range of temperatures. For this reason, the thermoelectric conversion system is a technology that can be applied to power generation using a thermal source in a limited narrow space such as an automobile, and can be applied to energy harvesting using environmental heat as a power source.

Recently, it has been considered that such energy harvesting is applied as a sensor power source for IoT. In order to operate a sensor, it is necessary to operate a low-power IC for controlling a sensor. However, the power specification thereof is approximately 100 uW, a voltage necessary for start is approximately 350 mV, and a voltage necessary for a normal operation is approximately 100 mV. In general, such power is minute, but in the case of IoT application, it is necessary to downsize the entire sensor module combined with the power source, and according to such needs, there is a limitation in the power source to be a supply source.

A downsized thermoelectric conversion module has been considered as a solution to such problems. The thermoelectric conversion module has a structure in which an N-type thermoelectric conversion material and a P-type thermoelectric conversion material are electrically connected in series by an electrode, and are disposed in parallel to a heat flow.

Examples of a technology relevant to the thermoelectric conversion module include JP 2006-186255 A.

In JP 2006-186255 A, a film-shaped substrate that contains two or more types of materials having different thermal conductivities and has flexibility is provided on both surfaces of a thermoelectric conversion module including a P-type thermoelectric element that is a thin film containing a P-type material and an N-type thermoelectric element that is a thin film containing an N-type material, and a material having a high thermal conductivity is positioned on a part of the outer surface of the substrate.

In the thermoelectric conversion module, it is convenient to install the module such that the maximum surface of the module is in contact with the thermal source, but heat is released in a vertical direction of the thermoelectric conversion module, and thus, it is difficult to generate a heat flow in an in-plane direction of the thermoelectric conversion module. WO2015163105A1 discloses a thermoelectric conversion element and method of manufacturing a thermoelectric conversion element.
JP2019179911A discloses a thermoelectric conversion module. US20120145209A1 discloses a thermoelectric element and a thermoelectric module including said thermoelectric element.

SUMMARY OF THE INVENTION

The invention is set out in the appended claims. An object of the invention is to efficiently generate a heat flow in an in-plane direction of a thermoelectric conversion module, in a thermoelectric conversion element.

A thermoelectric conversion element of one aspect of the invention is a thermoelectric conversion element converting heat into electricity by using a temperature difference, the element including: a substrate; a thermoelectric layer including a P-type thermoelectric layer and an N-type thermoelectric layer; an insulating portion provided on both surfaces of the thermoelectric layer; a heat releasing portion provided above the thermoelectric layer; and a heat receiving portion provided below the thermoelectric layer, in which a heat flow is generated such that the heat flow toward a direction perpendicular to a surface of the substrate is inhibited and is directed toward a direction parallel to the surface of the substrate to pass through the thermoelectric layer, by interfacial thermal resistance existing on an interface between the thermoelectric layer and the insulating portion.

A thermoelectric conversion element of one aspect of the invention is a thermoelectric conversion element converting heat into electricity by using a temperature difference, the element including: a substrate; a thermoelectric layer

2

including a P-type thermoelectric layer and an N-type thermoelectric layer; an insulating portion provided on both surfaces of the thermoelectric layer; a heat releasing portion provided above the thermoelectric layer; and a heat receiving portion provided below the thermoelectric layer, in which the thermoelectric layer includes a multi-layer film in which a first thermoelectric conversion material layer and a second thermoelectric conversion material layer containing a material different from that of the first thermoelectric conversion material layer are alternately laminated, and a heat flow is generated such that the heat flow toward a direction perpendicular to a surface of the substrate is inhibited and is directed toward a direction parallel to the surface of the substrate to pass through the thermoelectric layer, by the multi-layer film.

According to one aspect of the invention, a heat flow can be efficiently generated in an in-plane direction of a thermoelectric conversion module, in a thermoelectric conversion element.

BRIEF DESCRIPTION OF THE DRAWINGS

Fig. 1 is a schematic view illustrating a configuration of a π-type thermoelectric conversion element;
Fig. 2 is a graph showing a voltage curve;
Figs. 3A to 3C are schematic views illustrating a configuration of a thermoelectric conversion element of a first example;
Fig. 4A is a graph showing a voltage generation amount, and Fig. 4B is a graph showing a temperature difference;
Figs. 5A to 5D are schematic views illustrating a configuration of a thermoelectric conversion element of a second example;
Figs. 6A to 6F are graphs showing a relationship between the number of interfaces and an power density;
Figs. 7A and 7B are graphs showing a relationship between a dimension of a thermoelectric conversion module and a module voltage;
Fig. 8 is a schematic view illustrating a configuration of a thermoelectric conversion element of a first embodiment; and
Fig. 9 is a sectional view, a birds-eye view, and a top view of the thermoelectric conversion element of the first embodiment illustrated in Fig. 8.

DETAILED DESCRIPTION OF THE PREFERRED EMBODIMENTS

In the following embodiments, for the sake of convenience, the description will be divided into a plurality of sections or embodiments, as necessary, but unless otherwise specified, such sections or embodiments are relevant to each other, and one section or embodiment is in a relationship of a modification example, a detail, a supplemental description, and the like with a part or all of the other section or embodiment.

In addition, in the following embodiments, in the case of describing the number of components and the like (including the number of pieces, a numerical value, an amount, a range, and the like), unless otherwise specified or obviously limited to a specific number in principle, the number is not limited to the specific number, and may be a number greater or less than or equal to the specific number.

Further, in the following embodiments, it is obvious that constituents (also including a component step and the like) are not necessarily essential, unless otherwise specified or considered as obviously essential in principle. Similarly, in the following embodiments, in the case of describing the shape, a positional relationship, or the like of the constituents and the like, unless otherwise specified or considered as not obvious in principle, the shape includes a shape that is substantially approximated to or similar to the shape or the like. The same also applies to the numerical value and the range described above.

Hereinafter, the embodiments of the invention will be described in detail, with reference to the drawings. Note that, in all of the drawings for illustrating the embodiments, the same reference numerals will be applied to members having the same function, and the repeated description thereof will be omitted. In addition, in the following embodiments, unless necessary, the description of the same or similar parts will not be repeated in principle.

In addition, in the following embodiments, in the case of representing a range by A to B, unless otherwise specified, it is indicated that the range is greater than or equal to A and less than or equal to B.

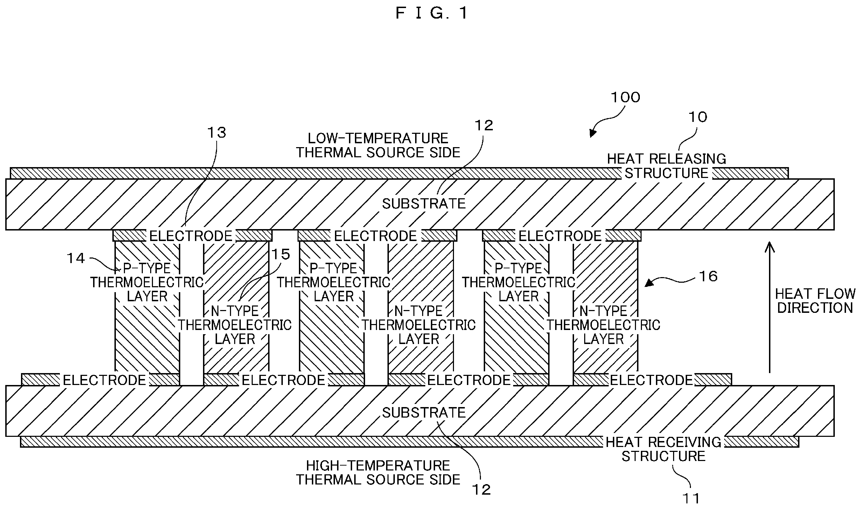

First, the configuration of a general π-type thermoelectric conversion element will be described with reference to Fig. 1.

As illustrated in Fig. 1, a π-type thermoelectric conversion element 100 has a heat releasing structure 10 on a low-temperature thermal source side, and has a heat receiving structure 11 on a high-temperature thermal source side. A thermoelectric layer 16 including a P-type thermoelectric layer 14 and an N-type thermoelectric layer 15 is provided between a pair of substrates 12 through an electrode 13.

In a case where a heat flow flows in a heat flow direction of an arrow in Fig. 1, a heat flow amount thereof is converted into power, and a voltage is generated between the electrodes. A power conversion efficiency and a power density (a power generation amount per unit area, W/m$^2$) of a thermoelectric conversion module are set by ZT that is a material performance index of a thermoelectric conversion material and a temperature difference that is applied to the thermoelectric conversion module.

Specifically, a conversion efficiency $\eta$ is represented by Expression 1 described below, and output P is represented by Expression 2 described below.

[Expression 1]

$$\eta = \frac{\Delta T}{T_H} \frac{\sqrt{1 + ZT_{ave}} - 1}{\sqrt{1 + ZT_{ave}} + \frac{T_L}{T_H}} \quad \cdots (1)$$

[Expression 2]

$$P = \eta \times Q = \frac{S^2}{P} \frac{W^2}{L} (1 + ZT_{ave})^{\frac{1}{2}} \Delta T^2 \quad \cdots (2)$$

Here, Q is a heat flow amount, $ZT = \alpha T/\kappa$ is defined, $\alpha$ is an output factor ($S^2/\rho$), S is a Seebeck coefficient, and $\rho$ is an electricity resistivity. In addition, $\kappa = \kappa_{ph} + \kappa_{el}$ is defined, and $\kappa_{ph}$ and $\kappa_{el}$ are a lattice thermal conductivity and an electron thermal conductivity, respectively. T is set to an absolute temperature, the temperature of a high-temperature portion is set to $T_H$, the temperature of a low-temperature portion is set to $T_L$, a temperature difference is set to $\Delta T = T_H - T_L$, and an average temperature is set to $T_{ave} = (T_H + T_L)/2$.

As described above, in a case where a temperature difference is suitably ensured, the conversion efficiency is improved by increasing the performance index ZT of the thermoelectric conversion material. In addition, it is found that the power density is improved by increasing both of the performance index ZT and the output factor $\alpha$.

On the other hand, examples of an approach to the improvement of the output of the module include a method for maximizing Q by optimizing a module structure. In the $\pi$-type thermoelectric conversion module, the height of the thermoelectric conversion material is designed to be high, in order to improve Q. In addition, from the viewpoint of reliability, a size of approximately 4 cm $\times$ 4 cm with a large sectional area is the mainstream.

Such a module has been developed in order to recover the exhaust heat of an automobile. On the other hand, there are needs for thinning and downsizing in IoT application, and thus, a method in which heat flows in the plane of a thin film is adopted as a method for handling the heat flow amount Q. In the case of a downsized thermoelectric conversion module, it is extremely difficult to draw the heat flow into the plane of the thin film, and various methods have been proposed.

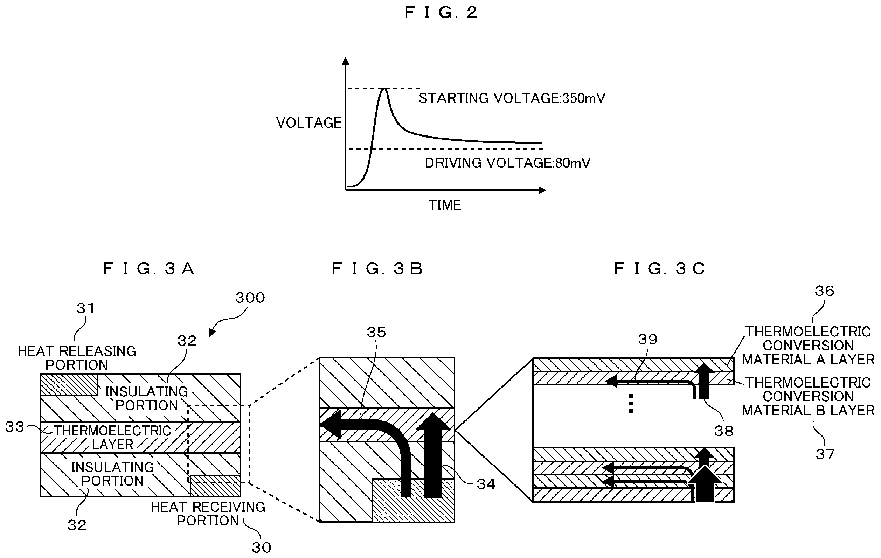

In particular, it is convenient to install the module such that the maximum surface of the module is in contact with the thermal source, but heat is released in a vertical direction of the module, and thus, it is difficult to generate the heat flow in an in-plane direction of the module. Simultaneously, as shown in Fig. 2, power of 100 uW which is a specification required in the IoT application, and it is difficult to satisfy a specification starting voltage of approximately 350 mV or approximately 100 mV.

As described above, in the $\pi$-type thermoelectric conversion element 100 illustrated in Fig. 1, a heat transfer direction from the thermal source is parallel to a voltage generation direction. In structure, bulk is necessary for a temperature difference. As a result thereof, a strong stress is applied, and the reliability decreases.

Therefore, a structure in which the heat flow flows into the thermoelectric material installed on the plane from the thermal source (a structure in which the heat transfer direction from the thermal source is vertical to the voltage generation direction) is required.

First example

A thermoelectric conversion element of a first example will be described with reference to Figs. 3A to 3C.

In the thermoelectric conversion element of the first example, a heat flow is efficiently generated in-plane direction of a thermoelectric conversion module. In the first example, the heat flow is efficiently generated in a thermoelectric conversion material layer of a downsized thermoelectric conversion module, and as a solution for preventing heat releasing toward a direction perpendicular to the maximum surface of the downsized thermoelectric conversion module, the thermoelectric conversion material layer is formed into a multi-layer film including a thermoelectric conversion material A layer and a thermoelectric conversion material B layer, and the dimension is adjusted. As a result thereof, as illustrated in Figs. 3A to 3C, the heat flow toward the direction perpendicular to the surface is inhibited by the effect of interfacial thermal resistance between the thermoelectric conversion material A layer and the thermoelectric conversion material B layer. As a result thereof, the heat flow can be generated in the thermoelectric conversion material layer.

A mechanism in which such a result is acquired will be described in detail, with reference to Figs. 3A to 3C. Here, Fig. 3A is a schematic view of a plane type thermoelectric conversion module 300 configuring a typical thermoelectric conversion element. Fig. 3B is a conceptual diagram of a state in which the heat flow is generated in the plane type thermoelectric conversion module 300. Fig. 3C is a conceptual diagram relevant to a heat flow direction in a case where the heat flow flows in the multi-layer film.

As illustrated in Fig. 3A, the thermoelectric conversion module 300 includes a heat receiving portion 30 and a heat releasing portion 31 having a high thermal conductivity, an insulating portion 32 having a low thermal conductivity, and a thermoelectric layer 33 having a thermal conductivity that is lower than that of the heat receiving portion 30 and is higher than that of the insulating portion 32.

Further, in a case where the thermal source is on the lower side of the plane type thermoelectric conversion module 300, and the upper side of the plane type thermoelectric conversion module 300 is air-cooled or water-cooled, broadly, the heat flux is generated toward the upper side from the lower side of the plane type thermoelectric conversion module 300.

In such a situation, the state of a heat flux in the vicinity of the heat receiving portion 30 is illustrated in Fig. 3B. A heat flow 35 that is a part of a heat flow 34 toward the upper side through the heat receiving portion 30 having a high thermal conductivity flows in an in-plane direction of the plane type thermoelectric conversion module 300 by changing the direction to flow along the thermoelectric layer 33 having a higher thermal conductivity than that of the insulating portion 32.

The present inventors have found that the conversion of the heat flow direction is caused not only by a difference in the thermal conductivities but also as a result on which the effect of the interfacial thermal resistance is reflected. In the first example, the material of the optimal insulating portion 32 and the thermoelectric layer 33 in which the effect of the interfacial thermal resistance can be actively utilized is used. In addition, the multi-layer film is formed as a preferred structure for allowing the effect of the interfacial thermal resistance to be more significantly exhibited, and the effect is considered.

As illustrated in Fig. 3C, the thermoelectric layer 33 is formed into a multi-layer structure including a thermoelectric conversion material A layer 36 and a thermoelectric conversion material B layer 37, and the heat flow direction is changed on the interface between the thermoelectric conversion material A layer 36 and the thermoelectric conversion material B layer 37. Specifically, the heat flow direction is changed to a heat flow direction 39 from a heat flow direction 38 on the interface between the thermoelectric conversion material A layer 36 and the thermoelectric conversion material B layer 37. As described above, it can be said that having the multi-layer structure is more preferred means for the conversion of the heat flow direction in which the interfacial thermal resistance is utilized.

As described above, power that is generated by the heat flow generated in the plane of the plane type thermoelectric conversion module 300 has a dimension in which a power generation amount is maximized or is greater than a desired voltage.

According to the first example, a downsized thermoelectric conversion module for IoT having 10 mm $\times$ 10 mm and a thickness of less than 1 mm can be provided.

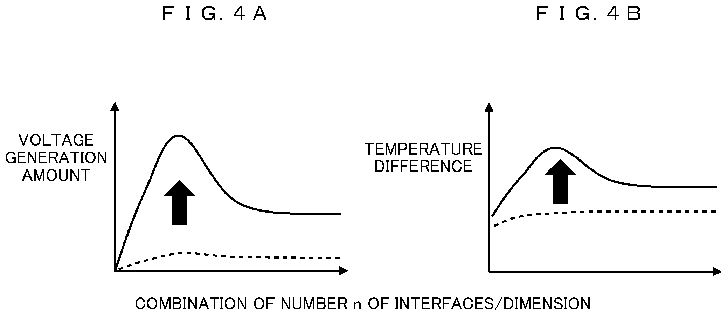

In particular, as schematically shown in Figs. 4A and 4B, a power generation element that is thin and downsized such as 10 mm $\times$ 10 mm but is greater than 100 uW can be provided by the number of interfaces for acquiring the effect of the optimal interfacial thermal resistance. Here, Fig. 4A is a graph showing a voltage generation amount, and Fig. 4B is a graph showing a temperature difference.

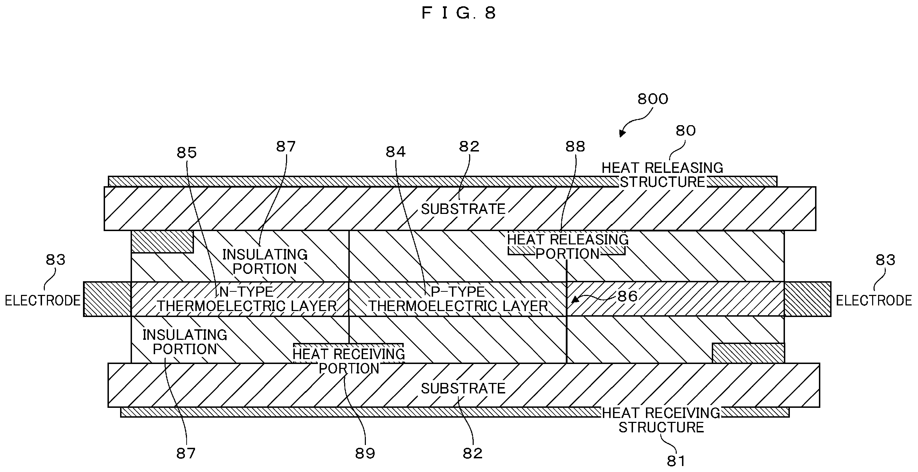

As described above, the thermoelectric conversion module 300 of the first example illustrated in Figs. 3A to 3C is a thermoelectric conversion element converting heat into electricity by using a temperature difference. The thermoelectric conversion module 300 includes the thermoelectric layer 33, the insulating portion 32 provided on both surfaces of the thermoelectric layer 33, the heat releasing portion 31 provided above the thermoelectric layer 33, and the heat receiving portion 30 provided below the thermoelectric layer 33. The thermoelectric layer 33, for example, includes a P-type thermoelectric layer and an N-type thermoelectric layer provided on the substrate (for example, refer to Fig. 8).

The thermoelectric layer 33 includes the multi-layer film in which a first thermoelectric conversion material layer (the thermoelectric conversion material A layer 36) and a second thermoelectric conversion material layer (the thermoelectric conversion material B layer 37) containing a material different from that of the first thermoelectric conversion material layer (the thermoelectric conversion material A layer 36) are alternately laminated. The heat flow is generated such that the heat flow toward the direction perpendicular to the surface of the substrate is inhibited and is directed toward a direction parallel to the surface of the substrate to pass through the thermoelectric layer 33, by the multi-layer film.

The interfacial thermal resistance exists between the first thermoelectric conversion material layer and the second thermoelectric conversion material layer, and the heat flow toward the direction parallel to the surface of the substrate is generated by the interfacial thermal resistance.

As illustrated in Fig. 8, the thermoelectric layer 33, for example, is configured such that the P-type thermoelectric layer and the N-type thermoelectric layer are alternately disposed in the direction parallel to the surface of the substrate, and each of the P-type thermoelectric layer and the N-type thermoelectric layer includes the multi-layer film in which the first thermoelectric conversion material layer (the thermoelectric conversion material A layer 36) and the second thermoelectric conversion material layer (the thermoelectric conversion material B layer 37) are alternately laminated. The heat releasing portion 31 and the heat receiving portion 30 have a thermal conductivity greater than the thermal conductivity of the insulating portion 32.

Next, the thermoelectric conversion material will be described.

For example, the first thermoelectric conversion material layer (the thermoelectric conversion material A layer 36) contains a Fe-based full-Heusler alloy, and the second thermoelectric conversion material layer (the thermoelectric conversion material B layer 37) contains silicon.

For example, the number of laminations of the first thermoelectric conversion material layer and the second thermoelectric conversion material layer configuring the multi-layer film is in a range of 20 to 150.

For example, a length (L) and a width (W) that are the dimension of the first thermoelectric conversion material layer and the second thermoelectric conversion material layer are in a relationship of W ≥ 80 um and L ≤ 80 um.

For example, the length (L) and the width (W) that are the dimension of the first thermoelectric conversion material layer and the second thermoelectric conversion material layer have a value in a range represented by two sets of L = 30 um and W ≥ 70 um and W ≥ 130 um and L = 50 um.

The present inventors have adopted the Fe-based full-Heusler alloy as the thermoelectric conversion material A layer 36 of the first example. The Fe-based full-Heusler alloy indicates an alloy in which an atom A is iron, in alloys having an $L2_1$ type crystalline structure represented by $A_2 BC$.

In such an alloy, atoms B and C are set to a suitable element, and thus, the alloy can be modulated to both of an N-type thermoelectric conversion material and a P-type thermoelectric conversion material. In addition, the thermoelectric conversion material B layer contains the Fe-based full-Heusler alloy, and Si or a BiTe material. Si or the BiTe material can also be modulated to both of the N-type thermoelectric conversion material and the P-type thermoelectric conversion material, in accordance with the type of additive element.

The core portion of the downsized thermoelectric conversion module 300 includes the heat receiving portion 30, the insulating portion 32, the thermoelectric conversion material A layer 36, and the thermoelectric conversion material B layer 37. The heat receiving portion 30 contains copper. The insulating portion 32 contains $SiO_2$, $AlO_2$, or polyimide.

In the dimension of each of the thermoelectric conversion material A layer 36 and the thermoelectric conversion material B layer 37, the thickness of the thin film is dA and dB, the width is W, and the length is L. In addition, d = dA + dB is defined.

In a case where the thickness of the multi-layer film including the thermoelectric conversion material A layer 36 and the thermoelectric conversion material B layer 37 is D, the number N of laminations is defined as D/d. In the dimension of the heat receiving portion 30, the thickness is **d2,** the width is W, and the length is l2.

Such a dimension is adjusted, and the effect of the interfacial thermal resistance of the thermoelectric conversion material A layer 36 and the thermoelectric conversion material B layer 37 is incorporated, and thus, the size of the heat flow is calculated. In a calculation method, a thermal diffusion equation is analyzed by a finite element method. The effect of the interfacial thermal resistance is incorporated by assuming a model in which virtual thermal resistance exists in an infinitely small thickness.

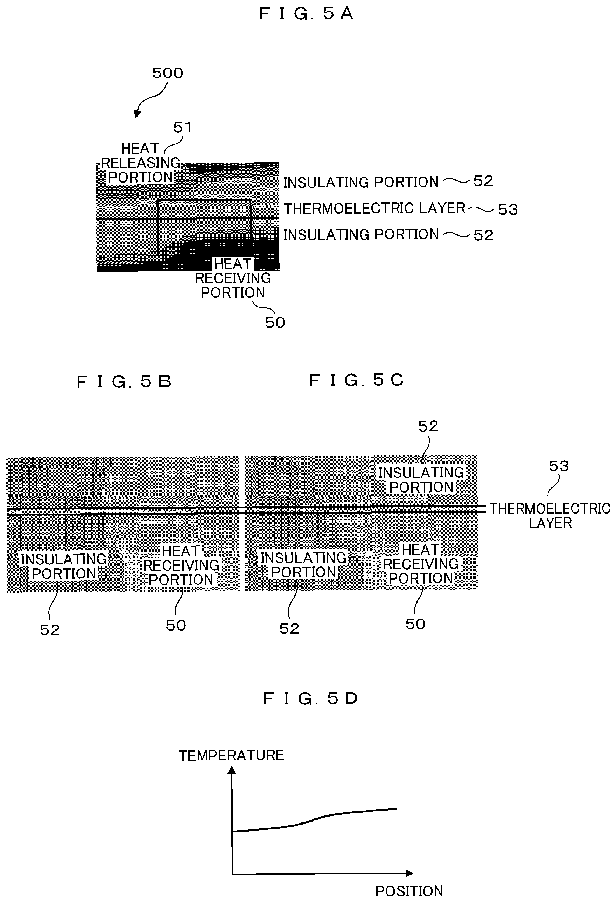

It is found that in a case where the multi-layer film including the thermoelectric conversion material A layer 36 and the thermoelectric conversion material B layer 37 is incorporated, a temperature distribution is obliquely generated, and an in-plane heat flux is generated in the thermoelectric conversion material layer (for example, refer to Fig. 5A).

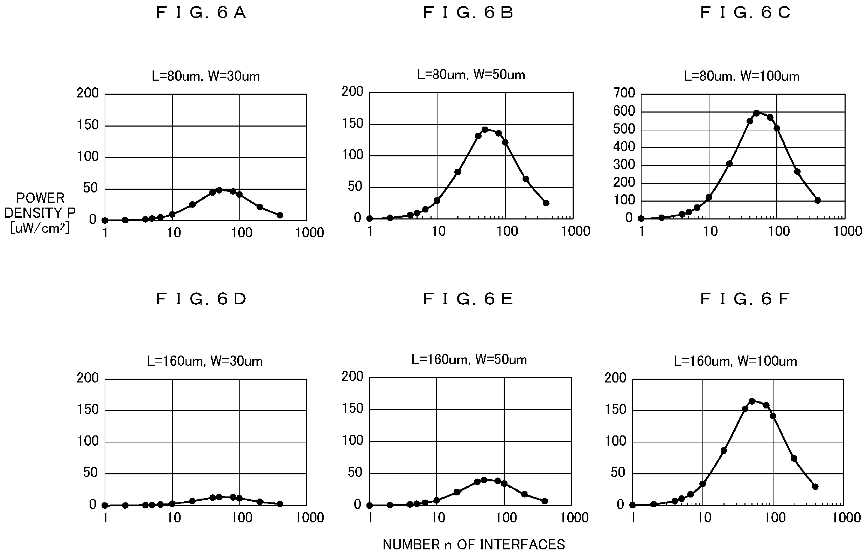

Results of plotting the power generation amount in a case where the thickness D of the multi-layer film is fixed to 2 $\mu$m and d is modulated to 2000 nm from 5 nm by such an in-plane heat flow, with respect to the number N of laminations, are shown in Fig. 6A to Fig. 6F. In Figs. 6A to 6F, six curves plotted with respect to each dimension of L and W are shown.

In Figs. 6A to 6F, it is found that the power generation amount is greater than 100 $\mu$W in several conditions. For example, it is found that in a case where the number N of laminations is 20 to 150, the power generation amount of greater than 100 $\mu$W can be provided, in a condition of (L, W) = (80 $\mu$m, 50 $\mu$m) (80 $\mu$m, 100 $\mu$m) and (160 $\mu$m, 100 $\mu$m).

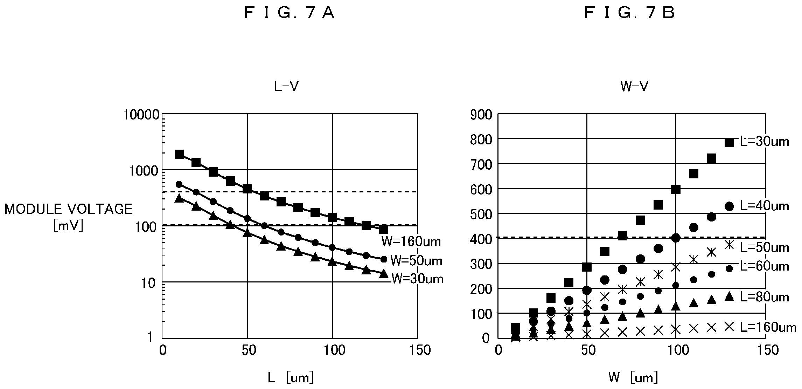

In addition, results of calculating a voltage from the obtained heat flux and of plotting the voltage with respect to W and L are shown in Figs. 7A and 7B.

From Figs. 7A and 7B, it is found that in a case where a voltage of 100 mV to be a specification is obtained, there is a dimensional constraint of W ≥ 80 $\mu$m and L ≤ 80 $\mu$m. In addition, it is found that in a case where a voltage of 350 mV to be a specification is obtained, a dimensional constraint in which W and L are a dimension in a region represented by two sets of a combination of W ≥ 70 $\mu$m and L = 30 $\mu$m and a combination of W ≥ 130 $\mu$m and L = 50 $\mu$m.

As described above, the form of the module obtained on the basis of the dimension obtained by calculation is as illustrated in Fig. 8, and the details thereof will be described below. Second example

A thermoelectric conversion element of a second example will be described with reference to Figs. 5A to 5D.

As illustrated in Fig. 5A, a plane type thermoelectric conversion module 500 configuring a thermoelectric conversion element includes a heat receiving portion 50 and a heat releasing portion 51 having a high thermal conductivity, an insulating portion 52 having a low thermal conductivity, and a thermoelectric layer 53 having a thermal conductivity that is lower than that of the heat receiving portion 50 and is higher than that of the insulating portion 52.

Further, in a case where a thermal source is on the lower side of the plane type thermoelectric conversion module 500, and the upper side of the plane type thermoelectric conversion module 500 is air-cooled or water-cooled, broadly, a heat flux is generated from the lower side toward the upper side of the plane type thermoelectric conversion module 500.

In Fig. 5A, a gray scale represents a temperature, and a low temperature is represented in the order from a high gray scale of a high temperature toward a low gray scale of a low temperature.

As illustrated in Fig. 5A, it is found that the gray scale obliquely represented from the heat releasing portion 51 toward the heat receiving portion 50, and a temperature gradient is also obliquely represented. The result thereof indicates that a temperature difference is generated in the plane of the module, and the heat flow is generated, in the plane type thermoelectric conversion module 500. In particular, it is expected that a temperature difference in the thermoelectric layer 53 is schematically illustrated as a plot of Fig. 5D. Here, in Fig. 5D, a horizontal axis represents a position, and a vertical axis represents a temperature.

The results of calculating an in-plane heat flow in the plane type thermoelectric conversion module 500 with respect to a case where the effect of interfacial thermal resistance is incorporated and a case where the effect of the interfacial thermal resistance is not incorporated are illustrated in Fig. 5B and Fig. 5C, respectively. Here, Fig. 5B illustrates a case where the effect of the interfacial thermal resistance is incorporated, and Fig. 5C illustrates a case where the effect of the interfacial thermal resistance is not incorporated.

Fig. 5B is the result of calculating an interfacial thermal resistance ratio with a combination of a Fe-based full-Heusler alloy and $SiO_2$. A gray scale in Fig. 5B and Fig. 5C represents the intensity of the heat flux, and in Fig. 5B, it is found that the intensity of the heat flux is high in the vicinity of the thermoelectric layer 53. The physical meaning of such a result indicates that heat is not capable of being excellently transferred to the insulating portion 52 from the thermoelectric layer 43, and the heat flow is generated in the plane of the thermoelectric layer 53, by the effect of the interfacial thermal resistance.

On the other hand, in Fig. 5C, a similar heat flux is not generated. In a comparison between Fig. 5B and Fig. 5C, it is found that in the case of selecting a combination of the thermoelectric layer 53 and the insulating portion 52 in which the effect of the interfacial thermal resistance is strongly exhibited, the direction of the heat flow is converted into an in-plane direction, and a desired temperature difference is generated in the plane type thermoelectric conversion module 500.

Note that, the effect is more significantly exhibited in the multi-layer film in which the number of interfaces is large (refer to Fig. 3C).

As described above, the thermoelectric conversion module 500 of the second example illustrated in Figs. 5A to 5D is a thermoelectric conversion element converting heat into electricity by using a temperature difference. The thermoelectric conversion module 500 includes the insulating portion 52 provided on both surfaces of the thermoelectric layer 53, the heat releasing portion 51 provided above the thermoelectric layer 53, and the heat receiving portion 50 provided below the thermoelectric layer 53. The thermoelectric layer 53, for example, includes the P-type thermoelectric layer and the N-type thermoelectric layer provided on the substrate (for example, refer to Fig. 8).

A heat flow is generated such that the heat flow toward a direction perpendicular to the surface of the substrate is inhibited and is directed toward a direction parallel to the surface of the substrate to pass through the thermoelectric layer 53, by the interfacial thermal resistance existing on the interface between the thermoelectric layer 53 and the insulating portion 52. The heat flow is generated in the plane of the interface between the thermoelectric layer 53 and the insulating portion 52 by the interfacial thermal resistance.

For example, the interfacial thermal resistance is adjusted to a value corresponding to a junction between a metal and an amorphous material, and thus, the heat flow is generated in the plane of the interface between the thermoelectric layer 53 and the insulating portion 52.

A difference is generated in effective interfacial thermal resistance, in accordance with the direction of the heat flow, in a junction portion of two layers having different Young's moduli. In other words, a temperature difference is maintained. In a case where the interfacial thermal resistance is adjusted to the value corresponding to the junction between a metal/an amorphous material, a heat amount is generated in the plane.

First embodiment

A thermoelectric conversion element of a first embodiment will be described with reference to Fig. 8.

As illustrated in Fig. 8, a thermoelectric conversion element 800 of the first embodiment has a heat releasing structure 80 on a low-temperature thermal source side, and has a heat receiving structure 81 on a high-temperature thermal source side. A thermoelectric layer 86 including a P-type thermoelectric layer 84 and an N-type thermoelectric layer 85 is provided between a pair of substrates 82 through an electrode 83. In the thermoelectric layer 86, the P-type thermoelectric layer 84 and the N-type thermoelectric layer 85 are alternately disposed in a direction parallel to the surface of the substrate 82. Then, an insulating portion 87 is disposed in the upper portion and the lower portion of the thermoelectric layer 86.

Further, a heat releasing portion 88 and a heat receiving portion 89 containing a material having a thermal conductivity greater than that of the insulating portion 87 are disposed in at least a part of the upper portion and the lower portion of the thermoelectric layer 86.

The heat releasing portion 88 and the heat receiving portion 89 are disposed in facing positions with respect to the center line in the direction parallel to the surface of the thermoelectric layer 86.

In Fig. 8, the heat releasing portion 88 is on the upper side in the drawing and is air-cooled or water-cooled, and it is assumed that the thermal source is on the lower side in the drawing. In the plane type thermoelectric conversion module, the P-type thermoelectric layer 84 and the N-type thermoelectric layer 85 are disposed to be in contact with each other in the same plane such that the P-type thermoelectric layer 84 and the N-type thermoelectric layer 85 can be connected in an electrically excellent state, and the insulating portions 87 are disposed to interposing the thermoelectric layer 86 therebetween.

Further, the heat receiving portion 89 and the heat releasing portion 88, for example, are disposed to be point-symmetric with respect to the center point of the P-type thermoelectric layer 84. Then, in the adjacent N-type thermoelectric layers 85, the heat receiving portion 89 and the heat releasing portion 88 are disposed to be line-symmetric with respect to the P-type thermoelectric layer 84.

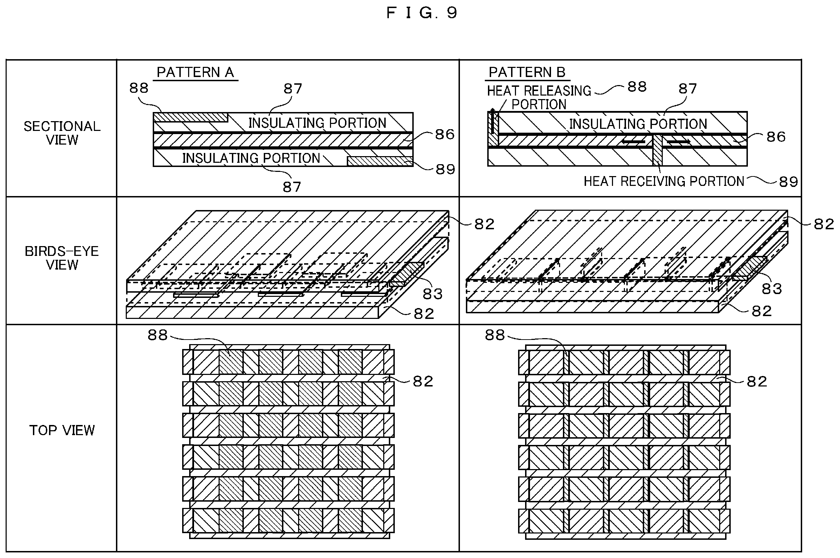

At this time, in consideration of an effect relevant to the conversion of a heat flux, various heat receiving portions 89 and heat releasing portions 88 are considered. Fig. 9 is a birds-eye view and a top view of the structure in the sectional view illustrated in Fig. 8.

As described above, structures in which the same effect can be obtained, as with patterns A and B illustrated in Fig. 9, are considered. In the plane type thermoelectric conversion module, the P-type thermoelectric layer 84 and the N-type thermoelectric layer 85 are disposed to be in contact with each other in the same plane such that the P-type thermoelectric layer 84 and the N-type thermoelectric layer 85 can be connected in an electrically excellent state.

In particular, in the thermoelectric conversion element 800 illustrated in the pattern B of Fig. 9, a part of the heat receiving portion 89 is positioned inside the thermoelectric layer 86, and a part of the heat releasing portion 88 is positioned inside the thermoelectric layer 86. A heat flow from the heat receiving portion 89 passes through the thermoelectric layer 86 in the direction parallel to the surface of the substrate 82 and is guided to the heat releasing portion 88. As described above, as with the pattern B of Fig. 9, it is naturally assumed that even in a case where the heat releasing portion 88 and the heat receiving portion 89 are in contact with the P-type thermoelectric layer 84 and the N-type thermoelectric layer 85, respectively, the same effect can be obtained.

According to the configuration described above, in the thermoelectric conversion element 800 of the first embodiment, a heat flow is generated in the direction parallel to the surface of the substrate 82 by the heat releasing portion 88 and the heat receiving portion 89, and thus, a voltage drop direction can be planarized. Accordingly, the thinning of the thermoelectric conversion module can be attained.

Next, a method for manufacturing a thermoelectric conversion material and a module will be described.

A desired method for obtaining the configuration of the thermoelectric conversion material has been described. For example, a method for forming a film on an insulator substrate by a magnetron sputtering method is desirable.

At this time, the film is formed in ultra-high vacuum. There is a method in which the substrate is not overheated, and the growth of the thin film is controlled such that a desired crystalline structure is obtained by an Ar partial pressure and sputtering power. Further, a desired pattern is formed by lithography, and a thermoelectric conversion module is formed.

At this time, a coating type film formation method may be used as a method for forming an insulating portion. In addition, a P-type thermoelectric conversion layer and an N-type thermoelectric conversion layer may be prepared on substrates, respectively, and then, two substrates may be bonded.

Finally, examples will be described.

Examples

In this example, a $Fe_2TiSi$-based full-Heusler alloy was adopted in a thermoelectric conversion material A layer, and Si was adopted in a thermoelectric conversion material B layer. Composition adjustment was performed such that the materials became an N-type thermoelectric conversion material and a P-type thermoelectric conversion material.

In the thermoelectric conversion material A layer, an alloy was adopted in which Fe, Ti, and Si were a main component, and composition adjustment was performed in the vicinity of an atomic weight ratio of Fe : Ti : Si = 50 (at%) : 25 (at%) : 25 (at%). Ti was substituted with approximately 5 at% of V to be the N-type thermoelectric conversion material, and Si was substituted with approximately 5 at% of Al to be the P-type thermoelectric conversion material.

In addition, in the thermoelectric conversion material B layer, phosphorus was added to be N-type Si, and boron was added to be P-type Si. In the thermoelectric conversion material layers, first, the N-type thermoelectric conversion material layer was formed on the insulator substrate passivated by an insulating layer, on which a heat receiving portion was formed in advance by lithography.

The magnetron sputtering method was used as a film formation method, and the film was formed in ultra-high vacuum. A multi-layer film was also formed as a part of the atmosphere. The thermoelectric conversion material layer after the film formation was formed into a desired shape by lithography.

An opening portion for the P-type thermoelectric conversion material layer was provided by applying and developing a resist after the film formation using the lithography. The P-type thermoelectric conversion material layer was formed as with the N-type thermoelectric conversion material layer by filling the opening portion.

Further, the formation of the P-type thermoelectric conversion material layer was completed through a liftoff step. After that, the formation of a core portion of a downsized thermoelectric conversion module is completed by forming a heat releasing portion and by filling the heat releasing portion with the insulating layer. As a result of measuring such a module, it is obviously checked that a desired voltage and desired power can be obtained.

## Claims

1. A thermoelectric conversion element converting heat into electricity by using a temperature difference, the element comprising:

   a substrate (82);
   a thermoelectric layer (33) having a first surface and a second surface and including a P-type thermoelectric layer and an N-type thermoelectric layer;
   an insulating portion (32) provided on the first surface and the second surface of the thermoelectric layer (33);
   a heat releasing portion (31) provided above the thermoelectric layer (33); and
   a heat receiving portion (30) provided below the thermoelectric layer (33);
   wherein a heat flow is generated such that the heat flow toward a direction perpendicular to a surface of the substrate (82) is inhibited and is directed toward a direction parallel to the surface of the substrate (82) to pass through the thermoelectric layer (33), by interfacial thermal resistance existing on an interface between the thermoelectric layer (33) and the insulating portion (32);
   **characterised in that** a part of the heat receiving portion (30) is positioned inside the thermoelectric layer (33);
   a part of the heat releasing portion (31) is positioned inside the thermoelectric layer (33); and
   the heat flow from the heat receiving portion (30) passes through the thermoelectric layer (33) in the direction parallel to the surface of the substrate (82) and is guided to the heat releasing portion (31).

2. The thermoelectric conversion element according to claim 1, wherein the heat releasing portion (31) and the heat receiving portion (30) have a thermal conductivity greater than a thermal conductivity of the insulating portion (32).

3. The thermoelectric conversion element according to claim 1, wherein the heat flow is generated in the interface between the thermoelectric layer (33) and the insulating portion (32) by the interfacial thermal resistance.

4. The thermoelectric conversion element according to claim 3, wherein the heat flow is generated in the interface between the thermoelectric layer (33) and the insulating portion (32) by adjusting the interfacial thermal resistance to a value corresponding to a junction between a metal and an amorphous material.

5. The thermoelectric conversion element according to claim 1, wherein the thermoelectric layer (33) is configured such that the P-type thermoelectric layer and the N-type thermoelectric layer are alternately disposed in the direction parallel to the surface of the substrate (82).

6. A thermoelectric conversion element converting heat into electricity by using a temperature difference, the element comprising:

   a substrate (82);
   a thermoelectric layer (33) having a first surface and a second surface and including a P-type thermoelectric layer and an N-type thermoelectric layer;
   an insulating portion (32) provided on the first surface and the second surface of the thermoelectric layer (33);
   a heat releasing portion (31) provided above the thermoelectric layer (33); and
   a heat receiving portion (30) provided below the thermoelectric layer (33);
   wherein the thermoelectric layer (33) includes a multi-layer film in which a first thermoelectric conversion material layer (36) and a second thermoelectric conversion material layer (37) containing a material different from that of the first thermoelectric conversion material layer (36) are alternately laminated;
a heat flow is generated such that the heat flow toward a direction perpendicular to a surface of the substrate (82) is inhibited and is directed toward a direction parallel to the surface of the substrate (82) to pass through the thermoelectric layer (33), by the multi-layer film;
**characterised in that** a part of the heat receiving portion (30) is positioned inside the thermoelectric layer (33); a part of the heat releasing portion (31) is positioned inside the thermoelectric layer (33); and
the heat flow from the heat receiving portion (30) passes through the thermoelectric layer (33) in the direction parallel to the surface of the substrate (82) and is guided to the heat releasing portion (31).

7. The thermoelectric conversion element according to claim 6, wherein interfacial thermal resistance exists between the first thermoelectric conversion material layer (36) and the second thermoelectric conversion material layer (37), and
the heat flow directed toward the direction parallel to the surface of the substrate (82) is generated by the interfacial thermal resistance.

8. The thermoelectric conversion element according to claim 6, wherein the thermoelectric layer (33) is configured such that the P-type thermoelectric layer and the N-type thermoelectric layer are alternately disposed in the direction parallel to the surface of the substrate (82), and
each of the P-type thermoelectric layer and the N-type thermoelectric layer includes the multi-layer film in which the first thermoelectric conversion material layer (36) and the second thermoelectric conversion material layer (37) are alternately laminated.

9. The thermoelectric conversion element according to claim 6, wherein the heat releasing portion (31) and the heat receiving portion (30) have a thermal conductivity greater than a thermal conductivity of the insulating portion (32).

10. The thermoelectric conversion element according to claim 6, wherein the first thermoelectric conversion material layer (36) contains a Fe-based full-Heusler alloy, and
the second thermoelectric conversion material layer (37) contains silicon.

11. The thermoelectric conversion element according to claim 6, wherein the number of laminations of the first thermoelectric conversion material layer (36) and the second thermoelectric conversion material layer (37) configuring the multi-layer film is in a range of 20 to 150.

12. The thermoelectric conversion element according to claim 6, wherein a length (L) and a width (W) that are a dimension of the first thermoelectric conversion material layer (36) and the second thermoelectric conversion material layer (37) are in a relationship of $W \geq 80$ $\mu$m and $L \leq 80$ $\mu$m.

13. The thermoelectric conversion element according to claim 6, wherein a length (L) and a width (W) that are a dimension of the first thermoelectric conversion material layer (36) and the second thermoelectric conversion material layer (37) have a value in a region represented by two sets of $L = 30$ $\mu$m and $W \geq 70$ $\mu$m and $W \geq 130$ $\mu$m and $L = 50$ $\mu$m.

**Patentansprüche**

1. Thermoelektrisches Umwandlungselement, das unter Verwendung einer Temperaturdifferenz Wärme in Elektrizität umwandelt, wobei das Element Folgendes umfasst:

ein Substrat (82);
eine thermoelektrische Schicht (33), die eine erste Fläche und eine zweite Fläche aufweist und die eine thermoelektrische P-Typ-Schicht und eine thermoelektrische N-Typ-Schicht beinhaltet;
einen Isolierabschnitt (32), der auf der ersten Fläche und der zweiten Fläche der thermoelektrischen Schicht (33) bereitgestellt ist;
einen Wärme freisetzenden Abschnitt (31), der über der thermoelektrischen Schicht (33) bereitgestellt ist; und
einen Wärme aufnehmenden Abschnitt (30), der unter der thermoelektrischen Schicht (33) bereitgestellt ist;
wobei ein Wärmefluss derart erzeugt wird, dass der Wärmefluss durch einen Grenzflächen-Wärmewiderstand, der auf einer Grenzfläche zwischen der thermoelektrischen Schicht (33) und dem Isolierabschnitt (32) vorliegt, in einer Richtung senkrecht zu einer Oberfläche des Substrats (82) gehemmt wird und in eine Richtung parallel zur Oberfläche des Substrats (82) geleitet wird, um durch die thermoelektrische Schicht (33) hindurchzutreten;

**dadurch gekennzeichnet, dass**

ein Teil des Wärme aufnehmenden Abschnitts (30) innerhalb der thermoelektrischen Schicht (33) angeordnet ist;

ein Teil des Wärme freisetzenden Abschnitts (31) innerhalb der thermoelektrischen Schicht (33) angeordnet ist; und

der Wärmefluss vom Wärme aufnehmenden Abschnitt (30) durch die thermoelektrische Schicht (33) hindurch in die Richtung parallel zur Oberfläche des Substrats (82) hindurchtritt und zum Wärme freisetzenden Abschnitt (31) geführt wird.

2. Thermoelektrisches Umwandlungselement nach Anspruch 1, wobei der Wärme freisetzende Abschnitt (31) und der Wärme aufnehmende Abschnitt (30) eine Wärmeleitfähigkeit aufweisen, die größer als die Wärmeleitfähigkeit als die des Isolierabschnitts (32) ist.

3. Thermoelektrisches Umwandlungselement nach Anspruch 1, wobei der Wärmefluss in der Grenzfläche zwischen der thermoelektrischen Schicht (33) und dem Isolierabschnitt (32) durch den Grenzflächen-Wärmewiderstand erzeugt wird.

4. Thermoelektrisches Umwandlungselement nach Anspruch 3, wobei der Wärmefluss in der Grenzfläche zwischen der thermoelektrischen Schicht (33) und dem Isolierabschnitt (32) durch Einstellen des Grenzflächen-Wärmewiderstands auf einen Wert erzeugt wird, der einem Übergang zwischen einem Metall und einem amorphen Metall entspricht.

5. Thermoelektrisches Umwandlungselement nach Anspruch 1, wobei die thermoelektrische Schicht (33) derart ausgelegt ist, dass die thermoelektrische P-Typ-Schicht und die thermoelektrische N-Typ-Schicht in der Richtung parallel zur Fläche des Substrats (82) abwechselnd angeordnet sind.

6. Thermoelektrisches Umwandlungselement, das unter Verwendung einer Temperaturdifferenz Wärme in Elektrizität umwandelt, wobei das Element Folgendes umfasst:

ein Substrat (82);

eine thermoelektrische Schicht (33), die eine erste Fläche und eine zweite Fläche aufweist und die eine thermoelektrische P-Typ-Schicht und eine thermoelektrische N-Typ-Schicht beinhaltet;

einen Isolierabschnitt (32), der auf der ersten Fläche und der zweiten Fläche der thermoelektrischen Schicht (33) bereitgestellt ist;

einen Wärme freisetzenden Abschnitt (31), der über der thermoelektrischen Schicht (33) bereitgestellt ist; und

einen Wärme aufnehmenden Abschnitt (30), der unter der thermoelektrischen Schicht (33) bereitgestellt ist;

wobei die thermoelektrische Schicht (33) einen Mehrschichtfilm umfasst, in dem eine erste Thermoelektrisches-Umwandlungsmaterial-Schicht (36) und eine zweite Thermoelektrisches-Umwandlungsmaterial-Schicht (37), die ein anderes Material als die erste Thermoelektrisches-Umwandlungsmaterial-Schicht (36) enthält, abwechselnd laminiert sind;

wobei ein Wärmefluss derart erzeugt wird, dass der Wärmefluss durch den Mehrschichtfilm in einer Richtung senkrecht zu einer Oberfläche des Substrats (82) gehemmt wird und in eine Richtung parallel zur Oberfläche des Substrats (82) geleitet wird, um durch die thermoelektrische Schicht (33) hindurchzutreten;

**dadurch gekennzeichnet, dass**

ein Teil des Wärme aufnehmenden Abschnitts (30) innerhalb der thermoelektrischen Schicht (33) angeordnet ist;

ein Teil des Wärme freisetzenden Abschnitts (31) innerhalb der thermoelektrischen Schicht (33) angeordnet ist; und

der Wärmefluss vom Wärme aufnehmenden Abschnitt (30) durch die thermoelektrische Schicht (33) hindurch in die Richtung parallel zur Oberfläche des Substrats (82) tritt und zum Wärme freisetzenden Abschnitt (31) geleitet wird.

7. Thermoelektrisches Umwandlungselement nach Anspruch 6, wobei zwischen der ersten Thermoelektrisches-Umwandlungsmaterial-Schicht (36) und der zweiten Thermoelektrisches-Umwandlungsmaterial-Schicht (37) ein Grenzflächen-Wärmewiderstand vorliegt und

wobei der Wärmefluss, der in die Richtung parallel zur Oberfläche des Substrats (82) geleitet wird, durch den Grenzflächen-Wärmewiderstand erzeugt wird.

8. Thermoelektrisches Umwandlungselement nach Anspruch 6, wobei die thermoelektrische Schicht (33) derart ausgelegt ist, dass die thermoelektrische P-Typ-Schicht und die thermoelektrische N-Typ-Schicht in der Richtung parallel zur Oberfläche des Substrats (82) abwechselnd angeordnet sind, und
wobei die thermoelektrische P-Typ-Schicht und die thermoelektrische N-Typ-Schicht jeweils den Mehrschichtfilm beinhaltet, in dem die erste Thermoelektrisches-Umwandlungsmaterial-Schicht (36) und die zweite Thermoelektrisches-Umwandlungsmaterial-Schicht (37) abwechselnd laminiert sind.

9.  Thermoelektrisches Umwandlungselement nach Anspruch 6, wobei der Wärme freisetzende Abschnitt (31) und der Wärme abgebende Abschnitt (30) eine Wärmeleitfähigkeit aufweisen, die größer als die Wärmeleitfähigkeit des Isolierabschnitts (32) ist.

10. Thermoelektrisches Umwandlungselement nach Anspruch 6, wobei die erste Thermoelektrisches-Umwandlungsmaterial-Schicht (36) eine vollständige Heusler-Legierung auf Fe-Basis enthält und wobei die zweite Thermoelektrisches-Umwandlungsmaterial-Schicht (37) Silicium enthält.

11. Thermoelektrisches Umwandlungselement nach Anspruch 6, wobei die Anzahl von Laminierungen der ersten Thermoelektrisches-Umwandlungsmaterial-Schicht (36) und der zweiten Thermoelektrisches-Umwandlungsmaterial-Schicht (37), welche den Mehrschichtfilm bilden, in einem Bereich von 20 bis 150 liegt.

12. Thermoelektrisches Umwandlungselement nach Anspruch 6, wobei eine Länge (L) und eine Breite (W), die eine Dimension der ersten Thermoelektrisches-Umwandlungsmaterial-Schicht (36) und der zweiten Thermoelektrisches-Umwandlungsmaterial-Schicht (37) sind, in einem Verhältnis von $W \geq 80\ \mu m$ und $L \leq 80\ \mu m$ stehen.

13. Thermoelektrisches Umwandlungselement nach Anspruch 6, wobei eine Länge (L) und eine Breite (W), die eine Dimension der ersten Thermoelektrisches-Umwandlungsmaterial-Schicht (36) und der zweiten Thermoelektrisches-Umwandlungsmaterial-Schicht (37) sind, einen Wert in einer Region aufweisen, der durch zwei Sätze von $L = 30\ \mu m$ und $W \geq 70$ und $W \geq 130$ und $L = 50$ dargestellt ist.

## Revendications

1.  Élément de conversion thermoélectrique convertissant de la chaleur en électricité en utilisant une différence de température, l'élément comprenant :

    un substrat (82) ;
    une couche thermoélectrique (33) présentant une première surface et une seconde surface et incluant une couche thermoélectrique de type P et une couche thermoélectrique de type N ;
    une partie isolante (32) prévue sur la première surface et la seconde surface de la couche thermoélectrique (33) ;
    une partie de libération de chaleur (31) prévue au-dessus de la couche thermoélectrique (33) ; et
    une partie de réception de chaleur (30) prévue en dessous de la couche thermoélectrique (33) ;
    dans lequel un flux de chaleur est généré de telle sorte que le flux de chaleur vers une direction perpendiculaire à une surface du substrat (82) est inhibé et est dirigé vers une direction parallèle à la surface du substrat (82) pour passer à travers la couche thermoélectrique (33), par l'intermédiaire d'une résistance thermique interfaciale existant sur une interface entre la couche thermoélectrique (33) et la partie isolante (32) ;
    **caractérisé en ce que**
    une partie de la partie de réception de chaleur (30) est positionnée à l'intérieur de la couche thermoélectrique (33) ;
    une partie de la partie de libération de chaleur (31) est positionnée à l'intérieur de la couche thermoélectrique (33) ; et
    le flux de chaleur provenant de la partie de réception de chaleur (30) passe à travers la couche thermoélectrique (33) dans la direction parallèle à la surface du substrat (82) et est guidé vers la partie de libération de chaleur (31).

2.  Élément de conversion thermoélectrique selon la revendication 1, dans lequel la partie de libération de chaleur (31) et la partie de réception de chaleur (30) présentent une conductivité thermique supérieure à une conductivité thermique de la partie isolante (32).

3.  Élément de conversion thermoélectrique selon la revendication 1, dans lequel le flux de chaleur est généré dans l'interface entre la couche thermoélectrique (33) et la partie isolante (32) par la résistance thermique interfaciale.

4.  Élément de conversion thermoélectrique selon la revendication 3, dans lequel le flux de chaleur est généré dans l'interface entre la couche thermoélectrique (33) et la partie isolante (32) en ajustant la résistance thermique interfaciale à une valeur correspondant à une jonction entre un métal et un matériau amorphe.

5. Élément de conversion thermoélectrique selon la revendication 1, dans lequel la couche thermoélectrique (33) est configurée de telle sorte que la couche thermoélectrique de type P et la couche thermoélectrique de type N sont disposées en alternance dans la direction parallèle à la surface du substrat (82).

6. Élément de conversion thermoélectrique convertissant de la chaleur en électricité en utilisant une différence de température, l'élément comprenant :

un substrat (82) ;
une couche thermoélectrique (33) présentant une première surface et une seconde surface et incluant une couche thermoélectrique de type P et une couche thermoélectrique de type N ;
une partie isolante (32) prévue sur la première surface et la seconde surface de la couche thermoélectrique (33) ;
une partie de libération de chaleur (31) prévue au-dessus de la couche thermoélectrique (33) ; et
une partie de réception de chaleur (30) prévue en dessous de la couche thermoélectrique (33) ;
dans lequel la couche thermoélectrique (33) inclut un film multicouche dans lequel une première couche de matériau de conversion thermoélectrique (36) et une seconde couche de matériau de conversion thermoélectrique (37) contenant un matériau différent de celui de la première couche de matériau de conversion thermoélectrique (36) sont stratifiées en alternance ;
un flux de chaleur est généré de telle sorte que le flux de chaleur vers une direction perpendiculaire à une surface du substrat (82) est inhibé et est dirigé vers une direction parallèle à la surface du substrat (82) pour passer à travers la couche thermoélectrique (33), par l'intermédiaire du film multicouche ;
**caractérisé en ce que**
une partie de la partie de réception de chaleur (30) est positionnée à l'intérieur de la couche thermoélectrique (33) ;
une partie de la partie de libération de chaleur (31) est positionnée à l'intérieur de la couche thermoélectrique (33) ; et
le flux de chaleur provenant de la partie de réception de chaleur (30) passe à travers la couche thermoélectrique (33) dans la direction parallèle à la surface du substrat (82) et est guidé vers la partie de libération de chaleur (31).

7. Élément de conversion thermoélectrique selon la revendication 6, dans lequel une résistance thermique interfaciale existe entre la première couche de matériau de conversion thermoélectrique (36) et la seconde couche de matériau de conversion thermoélectrique (37), et
le flux de chaleur dirigé vers la direction parallèle à la surface du substrat (82) est généré par la résistance thermique interfaciale.

8. Élément de conversion thermoélectrique selon la revendication 6, dans lequel la couche thermoélectrique (33) est configurée de telle sorte que la couche thermoélectrique de type P et la couche thermoélectrique de type N sont disposées en alternance dans la direction parallèle à la surface du substrat (82), et
chacune de la couche thermoélectrique de type P et de la couche thermoélectrique de type N inclut le film multicouche dans lequel la première couche de matériau de conversion thermoélectrique (36) et la seconde couche de matériau de conversion thermoélectrique (37) sont stratifiées en alternance.

9. Élément de conversion thermoélectrique selon la revendication 6, dans lequel la partie de libération de chaleur (31) et la partie de réception de chaleur (30) présentent une conductivité thermique supérieure à une conductivité thermique de la partie isolante (32).

10. Élément de conversion thermoélectrique selon la revendication 6, dans lequel la première couche de matériau de conversion thermoélectrique (36) contient un alliage de Heusler complet à base de Fe, et
la seconde couche de matériau de conversion thermoélectrique (37) contient du silicium.

11. Élément de conversion thermoélectrique selon la revendication 6, dans lequel le nombre de stratifications de la première couche de matériau de conversion thermoélectrique (36) et de la seconde couche de matériau de conversion thermoélectrique (37) configurant le film multicouche est dans une plage de 20 à 150.

12. Élément de conversion thermoélectrique selon la revendication 6, dans lequel une longueur (L) et une largeur (W) qui sont une dimension de la première couche de matériau de conversion thermoélectrique (36) et de la seconde couche de matériau de conversion thermoélectrique (37) sont dans une relation de W $\geq$ 80 um et L $\leq$ 80 $\mu$m.

13. Élément de conversion thermoélectrique selon la revendication 6, dans lequel une longueur (L) et une largeur (W) qui sont une dimension de la première couche de matériau de conversion thermoélectrique (36) et de la seconde couche de matériau de conversion thermoélectrique (37) présentent une valeur dans une région représentée par deux ensembles de L = 30 $\mu$m et W $\geq$ 70 $\mu$m, et W $\geq$ 130 $\mu$m et L = 50 $\mu$m.

F I G . 1

100

10

HEAT RELEASING STRUCTURE

LOW-TEMPERATURE THERMAL SOURCE SIDE

12

SUBSTRATE

13

ELECTRODE

14

P-TYPE THERMOELECTRIC LAYER

15

N-TYPE THERMOELECTRIC LAYER

ELECTRODE

16

P-TYPE THERMOELECTRIC LAYER

N-TYPE THERMOELECTRIC LAYER

ELECTRODE

SUBSTRATE

12

HIGH-TEMPERATURE THERMAL SOURCE SIDE

HEAT RECEIVING STRUCTURE

11

HEAT FLOW DIRECTION

15

FIG. 2

VOLTAGE

STARTING VOLTAGE:350mV

DRIVING VOLTAGE:80mV

TIME

FIG. 3A

HEAT RELEASING PORTION

31

INSULATING PORTION

32

THERMOELECTRIC LAYER

33

INSULATING PORTION

32

HEAT RECEIVING PORTION

30

300

FIG. 3B

35

34

FIG. 3C

THERMOELECTRIC CONVERSION MATERIAL A LAYER

36

THERMOELECTRIC CONVERSION MATERIAL B LAYER

37

38

39

F I G. 4 A

F I G. 4 B

VOLTAGE
GENERATION
AMOUNT

TEMPERATURE
DIFFERENCE

COMBINATION OF NUMBER n OF INTERFACES/DIMENSION

# F I G. 5 A

500

51

HEAT RELEASING PORTION

INSULATING PORTION ～ 52

THERMOELECTRIC LAYER ～ 53

INSULATING PORTION ～ 52

HEAT RECEIVING PORTION

50

# F I G. 5 B　　　　F I G. 5 C

52

INSULATING PORTION

53

THERMOELECTRIC LAYER

INSULATING PORTION

HEAT RECEIVING PORTION

INSULATING PORTION

HEAT RECEIVING PORTION

52　　　50　　　52　　　50

# F I G. 5 D

TEMPERATURE

POSITION

F I G. 6 A

L=80um, W=30um

F I G. 6 B

L=80um, W=50um

F I G. 6 C

L=80um, W=100um

POWER
DENSITY P
[uW/cm2]

F I G. 6 D

L=160um, W=30um

F I G. 6 E

L=160um, W=50um

F I G. 6 F

L=160um, W=100um

NUMBER n OF INTERFACES

EP 3 968 391 B1

19

F I G. 7 A

F I G. 7 B

FIG. 8

EP 3 968 391 B1

# FIG. 9

| | PATTERN A | PATTERN B |
|---|---|---|
| SECTIONAL VIEW | 88  87  INSULATING PORTION  86  INSULATING PORTION  87  89 | HEAT RELEASING PORTION  88  87  INSULATING PORTION  86  HEAT RECEIVING PORTION  89 |
| BIRDS-EYE VIEW | 82  83  82 | 82  83  82 |
| TOP VIEW | 88  82 | 88  82 |

EP 3 968 391 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006186255 A
- WO 2015163105 A1
- JP 2019179911 A
- US 20120145209 A1